(19) Europäisches Patentamt

European Patent Office

Office européen des brevets

(11) Veröffentlichungsnummer: **0 240 959 B1**

(12) **EUROPÄISCHE PATENTSCHRIFT**

(45) Veröffentlichungstag der Patentschrift: **27.11.91**

(21) Anmeldenummer: **87105017.5**

(22) Anmeldetag: **04.04.87**

(51) Int. Cl.5: **G01R 15/02**

(54) Zangenanlege-Messgerät.

(30) Priorität: **09.04.86 DE 3611864**

(43) Veröffentlichungstag der Anmeldung:
**14.10.87 Patentblatt 87/42**

(45) Bekanntmachung des Hinweises auf die
Patenterteilung:
**27.11.91 Patentblatt 91/48**

(84) Benannte Vertragsstaaten:
**DE FR GB**

(56) Entgegenhaltungen:
**EP-A- 0 036 935
EP-A- 0 067 527
DE-A- 2 710 675
DE-A- 2 918 329**

**PATENT ABSTRACTS OF JAPAN, Band 6, Nr.
136 (E-120)[1014], 23. Juli 1982; & JP-A-57 62
515 (TOKYO SHIBAURA DENKI K.K.)
15-04-1982**

(73) Patentinhaber: **Müller & Weigert GmbH
Kleinreuther Weg 88
W-8500 Nürnberg 10(DE)**

(72) Erfinder: **Rapp, Lothar
Hornschuchpromenade 19
W-8510 Fürth(DE)**

(74) Vertreter: **Dreiss, Uwe, Dr. jur. Dipl.-Ing. M.Sc.
et al
Patentanwälte Dreiss, Hosenthien & Fuhlendorf Gerokstrasse 6
W-7000 Stuttgart 1(DE)**

## Beschreibung

Die vorliegende Erfindung bezieht sich auf ein Zangenanlege-Meßgerät gemäß dem Oberbegriff des Anspruchs 1.

Bei derartigen bekannten Zangenanlege-Meßgeräten sind an die Anschlußelemente der Hallsensoren dünne, voneinander getrennte flexible Kabel angelötet. Die Zuleitungen sind daher in unregelmäßiger Form entlang dem Schenkel der Zange in das Meßgerät geführt (EP-B1 67 527).

Die Erfindung geht aus von der neuen Erkenntnis, daß durch die unterschiedliche Führung der Zuleitungen besonders bei Wechselstrom-Messungen infolge unterschiedlicher Beeinflußung durch das Magnetfeld in diesen unterschiedliche Spannungen induziert werden. Diese induzierte Spannung ist umso größer, je höher die Frequenz des gemessenen Wechselfeldes ist, und erreicht bei ungünstiger Leitungsführung Werte, die das eigentliche Hallsignal um ein mehrfaches übertreffen kann, so daß eine genaue Messung des Magnetfeldes, besonders bei hohen Frequenzen, unmöglich wird. Um dies zu vermeiden, muß die elektrische Verbindung zu den Sensoren auf besondere Weise erfolgen.

Ferner ist aus der EP-A 36 935 ein mit einem Hallsensor versehenes Gerät bekannt, bei dem die Zuleitungen mit endseitigen Anschlußkontaktflächen auf einer gedruckten Leiterplatte und der Hallsensor auf einer weiteren gedruckten Leiterplatte 15 aufgebracht sind, wobei beide Leiterplatten elektrisch leitend verbunden sind. Die gedruckte Leiterplatte ist mit verteilt angeordneten Steckerstiften versehen, die mit den anderen Enden der Zuleitungen elektrisch verbunden sind.

Aufgabe der vorliegenden Erfindung ist es, Störspannungen zu minimieren und/oder zu vergleichmäßigen, so daß eine bessere Kompensation mit einfachen Mitteln möglich ist.

Gelöst wird diese Aufgabe durch die im Anspruch 1 angegebenen Merkmale.

Hierdurch sind die in den einzelnen Leitern induzierten Spannungen bei jedem Meßgerät wenigstens annähernd gleich. Eine Kompensation kann daher z.B. für alle Meßgeräte mit einem einheitlichen Faktor vorgenommen werden.

Weitere vorteilhafte Einzelheiten der Erfindung sind in den Unteransprüchen enthalten und nachfolgend anhand der in der Zeichnung veranschaulichten Ausführungsbeispiele beschrieben. Dabei zeigen:

Fig. 1     eine Leiterfolie in der Draufsicht,

Fig. 2     die zugehörige, auf der Unterseite vorgesehene Leiterbahn in der Draufsicht in etwas kleinerem Maßstab,

Fig. 3 und 4     entsprechende Darstellungen für einen zweiten Hallsensor mit spiegelbildlicher Anschlußbelegung,

Fig. 5     die Zange eines Zangenanlege-Meßgerätes mit zwei Hallsensoren und

Fig. 6     einen zugeordneten Hallsensor im Maßstab der Leiterbahnen.

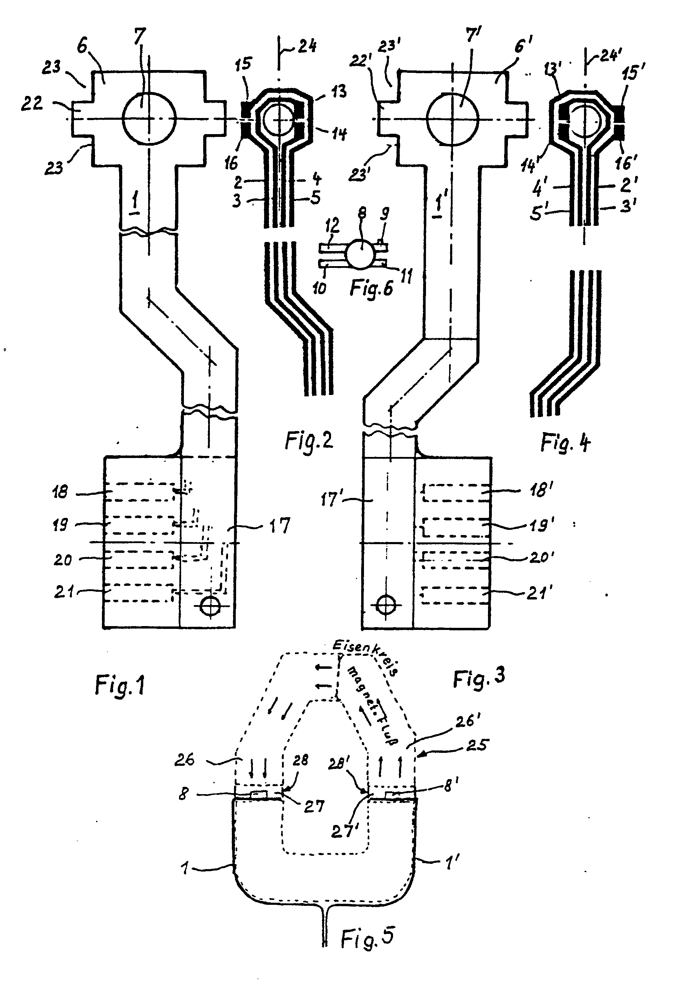

In Fig. 1 ist eine isolierende, flexible Leiterfolie 1 in der Draufsicht gezeigt, auf deren Unterseite die in Fig. 2 ebenfalls in Draufsicht dargestellten Leiterbahnen 2, 3, 4 und 5 vorgesehen sind. Die Leiterfolie 1 besitzt am oberen Ende 6 eine Aussparung 7, die an die Umrisse eines z.B. in Fig. 6 dargestellten Hallgenerators 8 angepaßt ist, so daß dieser beim Einsetzen lagefixiert ist. Der Hallsensor 8 ist im Maßstab der Leiterbahnen der Fig. 2 dargestellt. Am oberen Ende 6 enden die als Zuleitungen zu den Anschlüssen 9, 10, 11, 12 des Hallgenerators 8 dienenden Leiterbahnen 2, 3, 4, 5 in lötbaren Kontaktflächen 13, 14, 15, 16 für die Anschlüsse 9, 10, 11, 12 und am anderen Ende 17 enden sie in kontaktierbaren Anschlußflächen 18, 19, 20, 21, wie in Fig. 1 gestrichelt angedeutet. Die übrigen Leiterabschnitte der Leiterbahnen 2, 3, 4, 5 sind mit einer isolierenden Deckschicht abgedeckt.

Das obere Ende 6 kann Ansätze 22 in Form von Laschen oder Zungen oder Aussparungen 23 aufweisen, die als Lagefixierelemente beim Einsetzen des Haltesensors in seinen Wirkungsbereich dienen.

Anstelle der Aussparung 7 kann auch eine Prägung oder Vertiefung vorgesehen sein.

Die Fig. 3 und 4 zeigen eine entsprechende Ausführung, deren Positionen alle denen der Fig. 1 und 2 gleich ist, jedoch mit einem Index versehen sind. Bei dieser Ausführung, die in Verbindung mit derjenigen gemäß den Fig. 1 und 2 für eine in Fig. 5 schematisch dargestellte Anlegezange 25 eines Zangenanlege-Meßinstrument mit zwei Hallsensoren Verwendung findet, sind die Kontaktflächen 13', 14', 15', 16' und die Leiterbahnen 2', 3', 4', 5' bezüglich der Richtung der Achse 24 bzw. 24' der Leiterbahnen spiegelbildlich angeordnet. Die spiegelbildliche Anordnung kann auch zu einer beispielsweise senkrecht zu dieser Achse verlaufenden Achse vorgesehen sein.

In jedem Schenkel 26 bzw. 26' der Zange 25 ist ein Spalt 27 bzw. 27' angebracht, in den je ein Hallsensor 8, 8' mittels der Leiterfolie 1 bzw. 1' eingebracht und lagefixiert ist. Zur Lagefixierung können im Spalt 27, 27' in an sich bekannter Weise je ein Lagefixier-Zwischenglied 28, 28' vorgesehen sein, durch das die Lage der Hallsensoren 8 bzw. 8' in der Fläche des Schenkelquerschnitts genau fixiert wird. Bei der in Fig. 5 gezeigten Anordnung ist die induzierte Störspannung von vier Parametern abhängig:

- Stärke des Magnetfelds
- Frequenz des Magnetfelds
- Größe der Fläche, die von den elektrischen Zuleitungen gebildet wird
- Winkel, unter dem das Magnetfeld die Fläche schneidet, die von den elektrischen Zuleitungen gebildet wird.

Um die induktive Einstreuung zu vermindern, müssen die letzten beiden Parameter optimiert werden. Aus diesem Grund wurden die elektrischen Zuleitungen nicht mit Drähten, sondern mit einer flexiblen Leiterplatte realisiert, auf die der Hallsensor aufgelötet ist. Man sieht, daß es insgesamt drei verschiedene Flächen je Sensor gibt, in denen das Magnetfeld eine Spannung induzieren kann:

a) die Fläche des Sensors selbst, also des Halbleiterplättchens,

b) der Bereich der Leiterbahnen, der innerhalb des Eisenquerschnitts liegt,

c) die restliche von den Leiterbahnen gebildete Fläche außerhalb des Eisenkreises.

Diese drei Bereiche wurden auf folgende Weise möglichst klein gehalten:

zu a):  Verwendung eines Sensors mit möglichst kleiner Halbleiterfläche

zu b):  In diesen Bereich wird der größte Teil der Induktionsspannung gebildet, weil hier der gesamte magnetische Fluß des Eisenkreises senkrecht die Fläche schneidet, die von den Leiterbahnen gebildet wird. Das Layout in diesem Bereich wurde so gewählt, daß die Fläche zwischen den Leiterbahnen möglichst klein ist, und daß die verbleibende Induktionsspannung beider Sensoren möglichst gleich groß und um 180° phasenverschoben sind, so daß diese sich bei der nachfolgenden Addition der Hallspannungen zum größten Teil gegenseitig aufheben. Dies wird vor allem durch die genannte spiegelbildliche Anordnung erreicht.

zu c):  Außerhalb des Magnetkreises werden die flexiblen Leiterfolien parallel zum Eisenkreis geführt, so daß nur die aus der Eisenoberfläche austretenden Streufelder eine geringe Induktionsspannung verursachen können. Durch Verwendung einer anisotropen Eisenlegierung ("Silizium-Eisen") werden diese Streufelder noch weiter verringert.

**Patentansprüche**

1.  Zangenanlege-Meßgerät mit in wenigstens einem Schenkel (26) der Zange (25) in einem Spalt derselben lagefixiert angeordneten Hallsensor (8), dessen Zuleitungen (2,3,4,5) aus dem Spalt (27) herausgeführt und außen entlang dem Schenkel (26) in das Meßgerät geführt sind; **dadurch gekennzeichnet,** daß die als Leiterbahnen (2,3,4,5) ausgebildeten Zuleitungen zu den Anschlüssen (9,10,11,12) des Hallsensors (8) mit ihren endseitigen Anschlußkontaktflächen (13,14,15,16) und der Hallsensor (8) mit seinen Anschlüssen (9,10,11,12) auf einer gemeinsamen flexiblen Leiterfolie (1) angeordnet sind und die Anschlußkontaktflächen (13,14,15,16) mit den Anschlüssen (9,10,11,12) verbunden sind.

2.  Meßgerät nach Anspruch 1, dadurch gekennzeichnet, daß in der den Hallsensor (8) tragenden Leiterfolie (1) eine Vertiefung oder Aussparung (7) zur Lagefixierung des Hallsensors (8) vorgesehen ist.

3.  Meßgerät nach Anspruch 1 oder 2, dadurch gekennzeichnet, daß der den Hallsensor (8) tragende, im Spalt (27) vorgesehene Teil (6) der Leiterfolie (1) Lagefixieransätze (22) und/oder -Aussparungen (23) besitzt, mit denen sie im Spalt (27) unmittelbar oder über Lagefixierzwischenglieder (28) lagefixierbar ist.

4.  Meßgerät nach einem der Ansprüche 1 bis 3, dadurch gekennzeichnet, daß bei in jedem Schenkel (26,26') der Zange (25) vorgesehenem Hallsensor (8,8') die Leiterbahnen (2,3,4,5 bzw. 2',3',4',5') und Anschlüsse (9,10,11,12) auf der Leiterfolie (1,1') vorzugsweise bezüglich der Achse (24 bzw. 24') der Leiterbahnen (2,3,4,5 bzw. 2',3',4',5'), spiegelbildlich angebracht sind.

**Claims**

1.  Clip-on current measuring device comprising a Hall sensor which is fixed in a gap in at least one (26) of the legs of the clip (25) and whose leads (2,3,4,5) protrude from the gap (27) and run along the outside of the leg (26) into the measuring device, **characterized in** that the leads, in the form of conductor tracks (2,3,4,5) to the terminals (9,10,11,12) of the Hall sensor (8) with their terminal contact areas (13,14,15,16) at their ends and the Hall sensor (8) with its terminals (9,10,11,12) are disposed on a common flexible conductor foil (1) and the terminal contact areas (13,14,15,16) are connected to the terminals (9,10,11,12).

2.  A measuring device as claimed in Claim 1, characterized in that a depression or hole (7) is provided in the conductor foil (1) supporting the Hall sensor (8) for fixing the latter in position.

3. A measuring device as claimed in Claim 1 or 2, characterized in that the portion (6) of the conductor foil (1) supporting the Hall sensor (8), which portion is located in the gap (27), has lugs (22) and/or recesses (23) by which it can be fixed in the gap (27) directly or via intermediate members (28).

4. A measuring device as claimed in any one of Claims 1 to 3, characterized in that, if a Hall sensor (8,8') is provided in each leg (26,26') of the clip (25), the leads (2,3,4,5; 2',3',4',5') and the terminals (9,10, 11,12) on the conductor foil (1,1') are arranged symmetrically, preferably with respect to the axis (24; 24') of the conductor tracks (2,3,4,5; 2',3',4',5').

**Revendications**

1. Appareil de mesure à pince, comprenant un capteur à effet Hall(8) qui est disposé dans au moins une branche (26) de la pince (25), en étant fixé en position dans une fente de cette branche, et dont les fils d'alimentation (2,3,4,5) sortent de la fente (27) et sont amenés extérieurement, le long de la branche (26), à l'appareil de mesure, **caractérisé** en ce que les fils d'alimentation, réalisés sous forme de pistes conductrices (2,3,4,5) et menant aux connexions (9,10,11,12) du capteur à effet Hall (8), sont disposés par leurs faces terminales de contact de connexion (13,14,15,16) sur la même feuille souple imprimée (1) que les connexions (9,10,11,12) du capteur (8), et les faces de contact de connexion (13,14,15,16) sont reliées aux connexions (9,10,11,12).

2. Appareil de mesure selon la revendication 1, caractérisé en ce qu'un renfoncement ou un évidement (7) est prévu dans la feuille imprimée (1) portant le capteur à effet Hall (8), afin de fixer en position le capteur (8).

3. Appareil de mesure selon la revendication 1 ou 2, caractérisé en ce que la partie (6) de la feuille imprimée (1) portant le capteur à effet Hall (8) et prévue dans la fente (27), possède des appendices (22) et/ou des évidements (23) de fixation en position, par lesquels elle peut être fixée en position dans la fente (27), directement ou par des éléments intermédiaires de fixation en position (28).

4. Appareil de mesure selon l'une des revendications 1 à 3, caractérisé en ce qu'en présence d'un capteur à effet Hall (8,8') dans chaque branche (26,26') de la pince (25),les pistes conductrices (2,3,4,5 ou 2',3',4',5') et les connexions (9,10,11,12) sont disposées symétriquement sur la feuille imprimée (1,1'), de préférence par rapport à l'axe (24 ou 24') des pistes, conductrices (2,3,4,5 ou 2',3',4',5').

Fig.1

Fig.2

Fig.3

Fig.4

Fig.6

Fig.5

Eisenkreis

magnetfluß